**Europäisches Patentamt**

**European Patent Office**

**Office européen des brevets**

(19)

(11) Veröffentlichungsnummer: **0 104 390**
**B1**

# (12) EUROPÄISCHE PATENTSCHRIFT

(45) Veröffentlichungstag der Patentschrift:
08.04.87

(21) Anmeldenummer: **83107968.6**

(22) Anmeldetag: **11.08.83**

(51) Int. Cl.⁴: **H 01 L 29/743**

(54) **Abschaltbarer Thyristor.**

(30) Priorität: **18.08.82 DE 3230760**

(43) Veröffentlichungstag der Anmeldung:
**04.04.84 Patentblatt 84/14**

(45) Bekanntmachung des Hinweises auf die Patenterteilung:
**08.04.87 Patentblatt 87/15**

(84) Benannte Vertragsstaaten:
**CH DE FR GB LI NL SE**

(56) Entgegenhaltungen:
**EP-A-0 028 797**
**DE-A-3 018 542**

(73) Patentinhaber: **Siemens Aktiengesellschaft Berlin und München, Wittelsbacherplatz 2, D-8000 München 2 (DE)**

(72) Erfinder: **Spenke, Eberhard, Dr. phil, Siemens Strasse 1, D-8551 Pretzfeld (DE)**
Erfinder: **Stoisiek, Michael, Dr. rer. nat., Robert-Koch- Strasse 24, D-8012 Ottobrunn (DE)**

## Beschreibung

Die Erfindung bezieht sich auf einen abschaltbaren Thyristor nach dem Oberbegriff des Patentanspruchs 1.

Zum Löschen eines solchen Thyristors ist es an sich bekannt, die p-Basis über eine Elektrode mit einem von einer äußeren Räumstromquelle erzeugten, negativen Räumstromimpuls zu beaufschlagen, der zur Reduktion der positiven Defektelektronen des die p- und n-Basis überschwemmenden Elektronen-Defektelektronen-Plasmas führt. Elektronen des Plasmas sind dann nicht mehr raumladungsmäßig kompensiert und müssen zur Anode des Thyristors abfließen. Hierdurch wird das Plasma zunächst in der Umgebung dieser Elektrode und dann in weiter entfernten Bereichen unter dem n-Emitter abgebaut.

Nachteilig ist dabei, daß der durch den Thyristor fliessende Laststrom bei einer allmählichen Einschnürung des Plasmas zunächst kaum abnimmt und sich deshalb die Trägerdichte im Plasma zunächst erhöht, was dem angestrebten Zweck, nämlich der Ausräumung des Plasmas, entgegenwirkt. Daher ist ein hinreichend großer Räumstromimpuls erforderlich, der beispielsweise bei einem Laststrom von 100 A bis zu 50 A beträgt. Wird die zum Ausräumen erforderliche Amplitude des Räumstromimpulses nicht erreicht, so bleibt die Einschnürung des Plasmas stecken. Der Thyristor muß dann den praktisch nicht verringerten Laststrom mit eingeschnürtem Plasma führen, was unter Umständen seine Zerstörung zur Folge hat.

Aus der DE-A-29 45 324 ist andererseits ein Thyristor mit steuerbaren Emitter-Basis-Kurzschlüssen bekannt, die zum Zwecke des Löschens wirksam geschaltet werden. Eine äußere Räumstromquelle, die zum Löschen des Thyristors zugeschaltet wird, ist hierbei jedoch nicht vorgesehen.

Der vorliegenden Erfindung liegt die Aufgabe zugrunde, einen abschaltbaren Thyristor anzugeben, dem eine Räumstromquelle zuschaltbar ist, die eine schnelle und wirksame Abschnürung des Elektronen-Defektelektronen-Plasmas gewährleistet. Das wird erfindungsgemäß durch eine Ausbildung nach dem kennzeichnenden Teil des Patentanspruchs 1 erreicht.

Der mit der Erfindung erzielbare Vorteil besteht insbesondere darin, daß ein von der Räumstromquelle erzeugter Räumstromimpuls der Thyristorbasis an einer Mehrzahl von über die Thyristorfläche verteilten Stellen gleichzeitig zugeführt wird, und zwar jeweils über Schalttransistoren, die in die Randzonen der einzelnen in die Thyristorbasis eingefügten Emitterteile integriert sind. Hierdurch wird erreicht, daß der Räumstromimpuls gleichzeitige Einschnürungsvorgänge am Elektronen-Defektelektronen-Plasma unter den einzelnen Emitterteilen hervorruft, sodaß ein weitgehend homogener Verlauf des Abschaltvorgangs über der ganzen Thyristorfläche gewährleistet ist. Die als MIS-Feldeffekttransistoren ausgebildeten Schalttransistoren sind dabei so in die Randzonen der Emitterteile integriert, daß für sie ein Teil der Emitterfläche des Thyristors mit ausgenutzt werden kann.

Die Patentansprüche 2 und 3 sind auf bevorzugte Weiterbildungen eines Thyristors nach der Erfindung gerichtet. Bei einem nach Anspruch 2 ausgebildeten Thyristor ergibt sich der Vorteil, daß der Kondensator jeweils im Durchlaßzustand des Thyristors mit niedrigem Strom aufgeladen werden kann. Diese Aufladung erfolgt bei einem Thyristor nach Anspruch 3 automatisch durch den Laststrom.

Die Erfindung wird nachfolgend anhand der Zeichnung näher erläutert. Dabei zeigt:

Fig. 1 das Schaltungsprinzip eines nach der Erfindung ausgebildeten Thyristors,

Fig. 2 eine erste schaltungstechnische Durchbildung des Thyristors nach Fig. 1,

Fig. 3 eine zweite schaltungstechnische Durchbildung des Thyristors nach Fig. 1, und

Fig. 4 einen anderen nach der Erfindung ausgebildeten Thyristor.

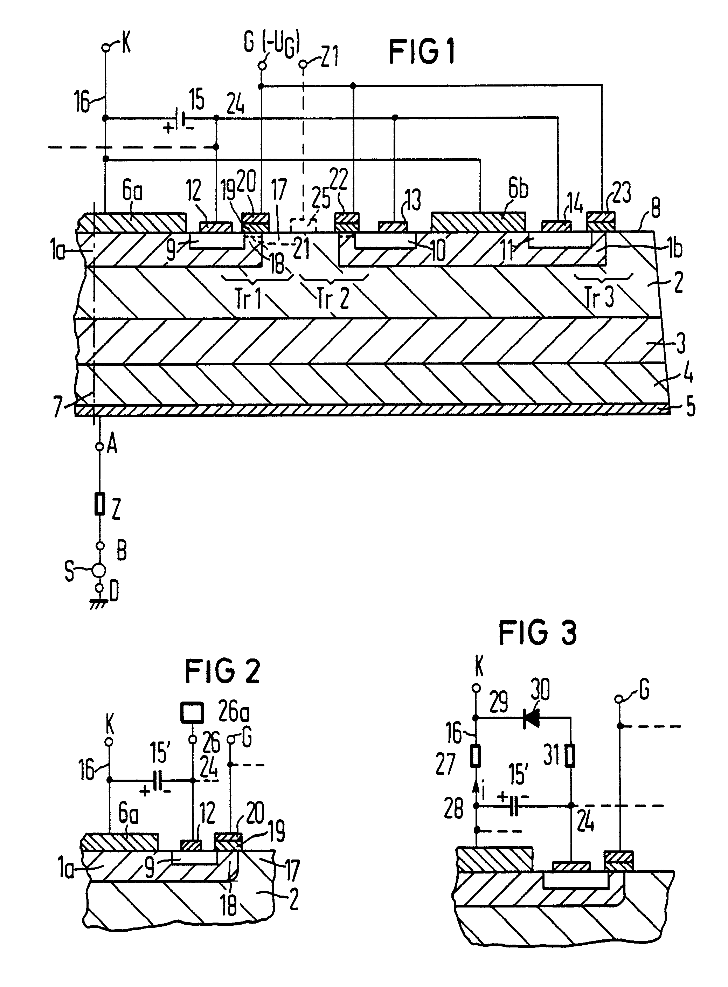

In Fig. 1 ist ein Thyristor mit einem aus dosiertem Halbleitermaterial, z. B. Silizium, bestehenden Halbleiterkörper dargestellt, der vier aufeinanderfolgende Schichten abwechselnder Leitungstypen aufweist. Von diesen bezeichnet man die n-leitende Schicht 1a, 1b als den n-Emitter, die p-leitende Schicht 2 als die p-Basis, die n-leitende Schicht 3 als die n-Basis und die p-leitende Schicht als den p-Emitter. Der p-Emitter ist mit einer anodenseitigen Elektrode 5 aus elektrisch leitendem Material, z.B. Aluminium, versehen, die einen Anschluß A aufweist, während der n-Emitter von einer mit einem Anschluß K versehenen kathodenseitigen Elektrode 6a, 6b aus elektrisch leitendem Material, z. B. Aluminium, kontaktiert wird.

Sieht man von den Teilen 1a und 1b ab, so weist der in Fig. 1 dargestellte Halbleiterkörper die Form einer flachen Scheibe auf, die zu einer Achse 7 rotationssymmetrisch ausgebildet ist. 1a und 1b bezeichnen zwei in den Halbleiterkörper eingefügte, streifenförmige Teile des n-Emitters, die sich jeweils senkrecht zur Bildebene im wesentlichen über die ganze Grenzfläche 8 des Halbleiterkörpers erstrecken. Die Teile 1a, 1b sind ihrerseits zu einer die Achse 7 enthaltenden Ebene symmetrisch, die senkrecht zur Bildebene liegt. Daher befindet sich ein weiteres solches Emitterteil symmetrisch zu 1b in dem nicht dargestellten Teil des Halbleiterkörpers. Jedes Teil, z. B. 1a oder 1b, des n-Emitters wird durch ein entsprechendes Teil, z. B. 6a oder 6b, der kathodenseitigen Elektrode kontaktiert, wobei diese Elektrodenteile untereinander elektrisch verbunden und an den Anschluß K geführt sind.

Vom Anschluß A gelangt man über einen Lastwiderstand Z von z. B. 10 Ω zum ersten Anschluß B einer Spannungsquelle S, die eine Spannung U von z. B. +1000 V liefert. Der zweite Anschluß D dieser Spannungsquelle liegt dabei auf Massepotential und ist mit K verbunden.

In die Teile 1a, 1b des n-Emitters sind inselförmige p-leitende Halbleitergebiete 9 bis 11 eingefügt, die sich bis zur Grenzfläche 8 erstrecken und in dieser von Elektroden 12 bis 14 kontaktiert werden. Diese sind an einen Schaltungspunkt 24 geführt, der über eine Stromquelle 15 mit der Kathodenzuleitung 16 verbunden ist. Das Halbleitergebiet 9, ein Teilbereich 17 der p-Basis 2 und ein Randgebiet 18 des n-Emitterteils 1a, das einen Kanalbereich darstellt und von einem durch eine dünne elektrisch isolierende Schicht 19 von der Grenzfläche 8 getrennten Gate 20 überdeckt ist, bilden einen über einen Anschluß G des Gate 20 steuerbaren MIS-Feldeffekt-Schalttransistor Tr1. Dieser verbindet in einem ersten Schaltzustand die p-Basis 2 mit der Elektrode 12 niederohmig. Unter der Annahme, daß die Struktur 9, 17, 18, 19, 20 einen Feldeffekttransistor des Anreicherungstyps darstellt, muß dem Anschluß G eine negative Steuerspannung -U$_G$ zugeführt werden, um einen p-leitenden Inversionskanal 21 unterhalb von 20 an der Grenzfläche 8 entstehen zu lassen, über den diese niederohmige Verbindung verläuft. Im zweiten Schaltzustand von Tr1, d. h. bei abgeschalteter Steuerspannung -U$_G$, ist die niederohmige Verbindung unterbrochen.

Unter Verwendung der inselförmigen p-leitenden Halbleitergebiete 10 und 11, die in das Teil 1b des n-Emitters eingefügt sind, sind analog hierzu weitere Schalttransistoren Tr2 und Tr3 an der Grenzfläche 8 vorgesehen, deren Gates 22 und 23 mit dem Anschluß G verbunden sind. Tr2 stellt je nach seinem Schaltzustand eine niederohmige Verbindung zwischen der p-Basis 2 und der Elektrode 13 her, Tr3 eine solche zwischen 2 und der Elektrode 14. Weiterhin ist der nicht dargestellte Teil des Thyristors mit Schalttransistoren versehen, die bezüglich der die Achse 7 enthaltenden Ebene symmetrisch zu Tr1 bis Tr3 angeordnet sind und gemeinsam mit letzteren über den Anschluß G gesteuert werden. Ihre Elektroden sind im Schaltungspunkt 24 den Elektroden 12 bis 14 parallel geschaltet.

Bei anliegender Spannung U wird der Thyristor beispielsweise durch einen positiven Zündstromimpuls, der dem Anschluß Z1 einer die p-Basis 2 kontaktierenden Zündelektrode 25 zugeführt wird, in den Durchlaßzustand geschaltet, in dem die p-Basis 2 und die n-Basis 3 mit einem Elektronen-Defektelektronen-Plasma überschwemmt sind. Dabei spielt die Art der Zündung für die vorliegende Erfindung keine Rolle.

Zum Löschen des Thyristors wird an den Anschluß G eine negative Steuerspannung -U$_G$, z. B. ein Spannungsimpuls, gelegt, wodurch unterhalb der Gates 20, 22, 23 usw. Inversionskanäle, z. B. 21, aufgebaut werden, über die niederohmige Verbindungen zwischen den Elektroden 12 bis 14 usw. und der p-Basis 2 verlaufen. Damit wird der Stromquelle 15 ein negativer Räumstromimpuls entnommen, der über die Schalttransistoren Tr1 bis Tr3 usw. den an die einzelnen Emitterteile, z. B. 1a, jeweils angrenzenden Teilbereichen, z. B. 17, der p-Basis zugeführt wird.

Der Räumstromimpuls führt zu einer Reduktion der positiven Defektelektronen des in der p-Basis 2 und der n-Basis 3 befindlichen Elektronen-Defektelektronen-Plasmas. Damit wandern negative Elektronen des Plasmas, die nicht mehr raumladungsmäßig kompensiert sind, zur anodenseitigen Elektrode 5 ab. Durch diese Vorgänge wird das Plasma von den neben den n-Emitterteilen, z. B. 1a und 1b, liegenden Teilbereichen der p-Basis, z. B. 17, her eingeschnürt. Die Stromquelle 15 liefert dabei einen Stromstoß solcher Größe, daß die das Plasma bildenden freien Ladungsträger z. B. in einer Zeit von einigen Mikrosekunden aus dem Thyristor entfernt werden.

Fig. 2 zeigt eine bevorzugte Ausgestaltung der Stromquelle 15 in Form eines Kondensators 15'. Der elektrodenseitige Anschluß desselben ist mit einer bei 26 angeschlossenen Stromquelle 26a verbunden. Diese hat die Aufgabe, den Kondensator 15' nach der Abgabe eines Räumstromimpulses wieder auf die ursprüngliche Spannung mit der eingezeichneten Polarität aufzuladen. Da im praktischen Betrieb zwischen aufeinanderfolgenden Räumstromimpulsen jeweils relativ lange Zeitabschnitte liegen, in denen der Thyristor im Durchlaßzustand betrieben wird, ist es möglich, den Kondensator 15' über die Stromquelle 26a mit relativ niedrigen Strömen aufzuladen. In Fig. 2 sind weitere, der Fig. 1 entsprechende Schaltungsteile mit den bereits verwendeten Bezugszeichen versehen.

Fig. 3 zeigt eine alternative Ausgestaltung des Thyristors nach Fig. 1, bei der die Stromquelle 26a von Fig. 2 durch andere Schaltungsteile ersetzt ist. Hierbei ist in die Kathodenzuleitung 16 ein ohmscher Widerstand 27 eingefügt, dessen thyristorseitiger Anschluß 28 mit dem Kondensator 15' verbunden ist. Der zweite Anschluß 29 ist mit der Kathode eines Gleichrichters 30 beschaltet, dessen Anode zweckmäßigerweise über einen Strombegrenzungswiderstand 31 an den Schaltungspunkt 24 gelegt ist. Bei dieser Schaltung ergibt sich durch den im Durchlaßzustand fließenden Laststrom i an dem Widerstand 27 ein Spannungsabfall, der über den Gleichrichter 30 zu einer Aufladung des Kondensators 15' in der eingezeichneten Polarität führt. Die übrigen Schaltungsteile der Fig. 3 entsprechen den gleichbezeichneten Schaltungsteilen der Figuren 1 und 2.

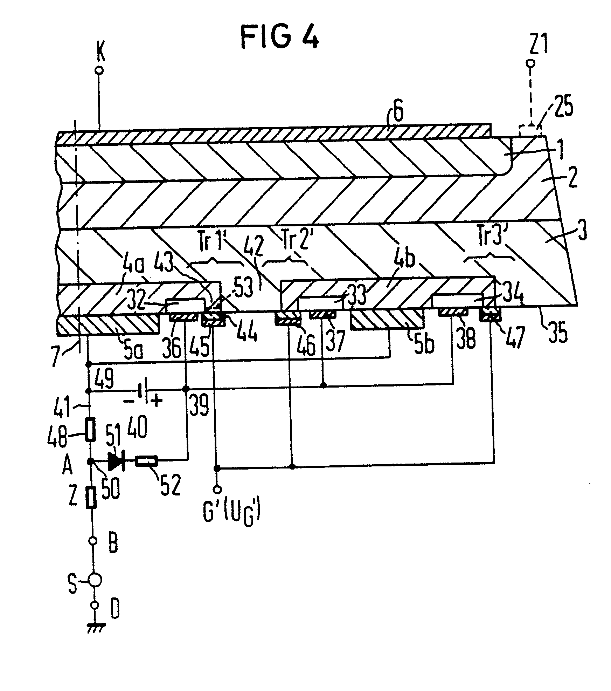

In Fig. 4 wird von einem Thyristor mit einem n-Emitter 1, einer p-Basis 2 und einer n-Basis 3 ausgegangen, dessen p-Emitter aus einzelnen Emitterteilen, z. B. 4a und 4b, besteht, die jeweils von Teilen, z. B. 5a und 5b, der anodenseitigen Elektrode kontaktiert werden. Letztere sind elektrisch miteinander verbunden und an den Anodenanschluß A geführt. Die den n-Emitter 1 kontaktierende Kathode 6 ist aus Gründen der besseren Übersicht ungeteilt dargestellt. In die Teile 4a, 4b des p-Emitters sind inselförmige, n-leitende Halbleitergebiete 32 bis 34 eingefügt, die sich bis zur Grenzfläche 35 des Thyristors erstrecken und in dieser von Elektroden 36 bis 38 kontaktiert werden. Diese sind an einen Schaltungspunkt 39 geführt, der über einen Kondensator 40 mit der Anodenzuleitung 41 verbunden ist. Das Halbleitergebiet 32, ein Teilbereich 42 der n-Basis 3 und ein Randgebiet 43 des p-Emitterteils 4a, das einen Kanalbereich darstellt und von einem durch eine dünne elektrisch isolierende Schicht 44 von der Grenzfläche 35 getrennten Gate 45 überdeckt ist, bilden einen über einen Anschluß G' des Gate 45 steuerbaren MIS-Feldeffekt-Schalttransistor Tr1'. Weitere Schalttransistoren Tr2' und Tr3' sind in analoger Weise mit Hilfe der n-Halbleitergebiete 33 und 34 aufgebaut und über ihre Gates 46 und 47, die mit dem Anschluß G' verbunden sind, steuerbar. In die Anodenzuleitung 41 ist ein ohmscher Widerstand 48 eingefügt, dessen anodenseitiger Anschluß 49 mit dem einen Anschluß des Kondensators 40 verbunden ist. Der andere Anschluß des Widerstandes 48, der dem Anodenanschluß A entspricht, ist über einen Gleichrichter 51 und einen zweckmäßigerweise in Serie zu diesem eingefügten Strombegrenzungswiderstand 52 mit dem Schaltungspunkt 39 verbunden. Der Kondensator 40 bildet zusammen mit den Schaltungsteilen 48, 51 und 52 eine zwischen den Schaltungspunkten 39 und 49 eingefügte Stromquelle.

Der Thyristor nach Fig. 4 wird beispielsweise durch einen positiven Zündstromimpuls, der der Zündelektrode 25 über den Anschluß Z1 zugeführt wird, in den Durchlaßzustand geschaltet. Zum Löschen wird an den Anschluß G' eine positive Steuerspannung $U_G'$, z. B. ein Spannungsimpuls, gelegt, wodurch unterhalb der Gates 45 bis 47 Inversionskanäle, z. B. 53, aufgebaut werden, über die jeweils niederohmige Verbindungen zwischen den Elektroden 36 bis 38 und der n-Basis 3 verlaufen. Damit wird dem Kondensator 40 ein positiver Räumstromimpuls entnommen, der über Tr1' bis Tr3' den an die Teile 4a und 4b jeweils lateral angrenzenden Teilbereichen der n-Basis, z. B. 42, zugeführt wird. Hierdurch ergeben sich analog zu dem oben beschriebenen Effekt, der mit den Schalttransistoren Tr1 bis Tr3 erreicht wird, Einschnürungen des in der p-Basis 2 und der n-Basis 3 befindlichen Elektronen-Defektelektronen-Plasmas. Zu einem sicheren Löschen des Thyristors muß der von 40 gelieferte Räumstromimpuls so groß sein, daß die das Plasma bildenden freien Ladungsträger z. B. in einer Zeit von einigen Mikrosekunden aus dem Thyristor entfernt werden.

Eine Weiterbildung des Ausführungsbeispiels nach Fig. 4 besteht darin, daß auch der n-Emitter 1 in mehrere Teile, z. B. 1a und 1b gemäß Fig. 1, aufgeteilt ist und kathodenseitige steuerbare Schalttransistoren Tr1 bis Tr3 usw. in der bereits beschriebenen Weise vorgesehen sind. In diesem Fall werden Tr1 bis Tr3 usw. über ihren Anschluß G (Fig. 1) und Tr1' bis Tr3' usw. über ihren Anschluß G' angesteuert; die ersteren mit einer negativen Steuerspannung $-U_G$, die letzteren mit einer positiven Steuerspannung $U_G'$.

Selbstverständlich kann der Kondensator 40 in dem Ausführungsbeispiel nach Fig. 4 über den Schaltungspunkt 39 mit einer weiteren Stromquelle verbunden sein, über die er in den Durchlaßphasen des Thyristors mit der eingezeichneten Polarität aufgeladen wird. Hierbei entfallen dann der Gleichrichter 51 und der Strombegrenzungswiderstand 52 sowie der ohmsche Widerstand 48 in der Anodenzuleitung 41.

In Abweichung von den bisher beschriebenen Ausführungsformen der Erfindung können die Emitterteile 1a, 1b usw. in an sich bekannter Weise zu der Achse 7 (Fig. 1) rotationssymmetrisch ausgebildet sein. In diesem Fall ergibt sich für das Teil 1a eine kreisförmige laterale Begrenzung während das Teil 1b die Form eines Kreisringes aufweist. Weiterhin kann der n-Emitter auch in eine Vielzahl von Emitterteilen 1a, 1b usw. aufgeteilt sein, die sich gradlinig, ringförmig oder in an sich bekannter Weise über die Grenzfläche 8 des Thyristors verteilen. Die einzelnen n-Emitterteile 1a, 1b usw. können auch miteinander zusammenhängend ausgebildet sein. Dies ist insbesondere so zu verstehen, daß die zusammenhängenden Emitterteile eine Emitterschicht bilden, die mit einer Mehrzahl von Ausnehmungen versehen ist. Auch in diesem Fall sind die MIS-Feldeffekt-Schalttransistoren randseitig zu den Emitterteilen, d. h. in den genannten Ausnehmungen, angeordnet.

Die anhand der Fig. 1 beschriebenen Konfigurationen der n-Emitterteile 1a, 1b usw. sowie die vorstehend beschriebenen Abweichungen hiervon beziehen sich sinngemäß auch auf die p-Emitterteile 4a, 4b usw. nach Fig. 4.

**Patentansprüche**

1. Abschaltbarer Thyristor mit einem Halbleiterkörper, der einen von einer kathodenseitigen Elektrode (6a, 6b) kontaktierten n-Emitter (1a, 1b) mit einer angrenzenden p-Basisschicht (2) und einen von einer anodenseitigen Elektrode (5) kontaktierten p-Emitter (4) mit einer angrenzenden n-Basisschicht (3) aufweist, wobei die Basisschichten (2, 3) durch einen pn-Übergang voneinander getrennt sind, bei dem wenigstens einer der Emitter aus einer Mehrzahl von Emitterteilen (1a, 1b) besteht, und bei dem an den Randzonen dieser Emitterteile Schalttransistoren (Tr1, Tr2) vorgesehen sind, die jeweils ein in das n(p)-Emitterteil (1a) eingefügtes p(n)-Halbleitergebiet (9, 32), einen Teilbereich (21, 42) der p(n)-Basisschicht (2, 3) und einen dazwischen liegenden Kanalbereich (18, 43) umfassen, wobei der letztere von einem gegen eine Grenzfläche (8, 35) des Halbleiterkörpers isolierten, mit einem Steueranschluß (G, G') versehenen Gate (20, 45) überdeckt ist, dadurch gekennzeichnet, daß die p(n)-Halbleitergebiete (9, 32) von Elektroden (12, 36) kontaktiert sind, die über eine zum Löschen des Thyristors vorgesehene Stromquelle (15, 40) mit der Kathodenzuleitung (Anodenzuleitung) (16, 41) verbunden sind, und daß der positive (negative) Pol der Stromquelle (15, 40) kathodenseitig (anodenseitig) angeordnet ist.

2. Abschaltbarer Thyristor nach Anspruch 1, dadurch gekennzeichnet, daß die Stromquelle (15) durch einen Kondensator (15', 40) gebildet ist, dessen elektrodenseitiger Anschluß (24, 39) mit einer weiteren Stromquelle (26a) beschaltet ist.

3. Abschaltbarer Thyristor nach Anspruch 1, dadurch gekennzeichnet, daß die Stromquelle (15) durch einen Kondensator (15', 40) gebildet ist, der zwischen die Elektrode (12, 36) und den thyristorseitigen Anschluß (28, 49) eines in die Kathodenzuleitung (Anodenzuleitung) (16, 41) eingefügten Widerstandes (27, 48) geschaltet ist.

4. Abschaltbarer Thyristor nach Anspruch 3, dadurch gekennzeichnet, daß der aus dem Kondensator (15', 40) und dem eingefügten Widerstand (27, 48) bestehenden Serienschaltung ein Gleichrichter (30, 51) parallel geschaltet ist.

5. Abschaltbarer Thyristor nach Anspruch 4, dadurch gekennzeichnet, daß ein Strombegrenzungswiderstand (31, 52) in Serie zum Gleichrichter (30, 51) angeordnet ist.

6. Abschaltbarer Thyristor nach einem der Ansprüche 1 bis 5, dadurch gekennzeichnet, daß die n(p)-Emitterteile (1a, 1b, 4a, 4b) untereinender zusammenhängend ausgebildet sind.

**Claims**

1. A turn-off thyristor, with a semiconductor body having an n-doped emitter (1a, 1b) contacted by a cathode-side electrode (6a, 6b), an adjoining p-doped base layer (2), adjoined by an n-doped base layer (3), and a p-doped emitter (4) contacted by an anode-side electrode (5), whereby the base layers (2, 3) are each separated by a pn-junction, where at least one of the emitters consists of a plurality of emitter components (1a, 1b), and where switching transistors (Tr1, Tr2) arranged at the edge of these emitter components each comprise a p(n)-doped semiconductor zone (9, 32) inserted into the n(p)-doped emitter component (1a), a subsidiary zone (21, 42) of the p(n)-doped base zone (2, 3) and an interposed channel zone (18, 43), where the latter is covered by a gate (20, 45) insulated from a boundary surface (8, 35) of the semiconductor body and provided with a control terminal (G, G'), characterised in that the p(n)-doped semiconductor zones (9, 32) are contacted by electrodes (12, 36) connected to the cathode supply line (anode supply line) (16, 41) via a current source (15, 40) provided to extinguish the thyristor, and that the positive (negative) pole of the current source (15, 40) is arranged at the cathode (anode) side.

2. A turn-off thyristor as claimed in Claim 1, characterised in that the current source (15) is formed by a capacitor (15', 40) whose electrode-side terminal (24, 39) is connected to a further current source (26a).

3. A turn-off thyristor as claimed in Claim 1, characterised in that the current source (15) is formed by a capacitor (15', 40) connected between the electrode (12, 36) and the thyristor-side terminal (28, 49) of a resistor (27, 48) in the cathode supply line (anode supply line), (16, 41).

4. A turn-off thyristor as claimed in Claim 3, characterised in that the series arrangement composed of the capacitor (15', 40) and the interposed resistor (27, 48) is connected in parallel with a rectifier (30, 51).

5. A turn-off thyristor as claimed in Claim 4, characterised in that a current-limiting resistor (31, 52) is in series with the rectifier (30, 51).

6. A turn-off thyristor as claimed in one of Claims 1 to 5, characterised in that the n(p)-doped emitter components (1a, 1b, 4a, 4b) are each designed so as to be interconnected.

**Revendications**

1. Thyristor pouvant être amené à l'état bloqué, comportant un corps semiconducteur qui possède un émetteur de type n (1a, 1b) contacté par une électrode (6a, 6b) située du côté de la cathode et possédant une couche de base contiguë de type p (2), et un émetteur de type p (4) contacté par une électrode (5) située du côté de l'anode et munie d'une couche de base contiguë de type n (3), les couches de base (2, 3) étant séparées l'une de l'autre par une jonction pn, et dans lequel au moins l'un des émetteurs est constitué par une pluralité d'éléments d'émetteur (1a, 1b) et dans lequel il est prévu, dans les zones marginales de ces éléments d'émetteur, des transistors de commutation (TR1, TR2), qui incluent respectivement une région semiconductrice (9, 32) de type p (n), insérée dans l'élément d'émetteur (1a) de type n (p), une zone partielle (21, 42) de la couche de base (2, 3) de type p (n) et une zone de canal (18, 43) intercalée entre ces parties, cette dernière zone étant recouverte par une grille (20, 45) isolée par rapport à une interface (8, 35) du corps semiconducteur et munie d'une borne de commande (G, G'), caractérisé par le fait que les régions semiconductrices (9, 32) de type p (n) sont contactées par des électrodes (12, 36) qui sont reliées par l'intermédiaire d'une source de courant (15, 40) prévue pour l'extinction du thyristor, au conducteur d'alimentation de cathode (conducteur d'alimentation d'anode) (16, 41), et que le pôle positif (négatif) de la source de courant (15, 40) est disposé du côté de la cathode (du côté de l'anode).

2. Thyristor pouvant être placé à l'état bloqué suivant la revendication 1, caractérisé par le fait que la source de courant (15) est formée par un condensateur (15', 40), dont la borne (24, 39), située du côté de l'électrode, est raccordée à une autre source de courant (26a).

3. Thyristor pouvant être placé à l'état bloqué suivant la revendication 1, caractérisé par le fait que la source de courant (15) est formée par un condensateur (15', 40) qui est monté entre l'électrode (12, 36) et la borne (28, 49), située du côté du thyristor, d'une résistance (27, 48) insérée dans le conducteur d'alimentation de cathode (conducteur d'alimentation d'anode) (16, 41).

4. Thyristor pouvant être placé à l'état bloqué suivant la revendication 3, caractérisé par le fait qu'un redresseur (30, 51) est branché en parallèle avec le circuit série constitué par le condensateur (15', 40) et la résistance insérée (27, 48).

5. Thyristor pouvant être placé à l'état bloqué suivant la revendication 4, caractérisé par le fait qu'une résistance (31, 52) de limitation du courant est montée en série avec le redresseur (30, 51).

6. Thyristor pouvant être placé à l'état bloqué suivant l'une des revendications 1 à 5, caractérisé par le fait que les éléments d'émetteur (1a, 1b, 4a, 4b) de type n (p) sont réalisés de manière à être reliés entre eux.

FIG 1

FIG 2

FIG 3

# FIG 4